# EUROPÄISCHE PATENTSCHRIFT

(11) **EP 0 299 987 B1**
(45) Veröffentlichungstag und Bekanntmachung des Hinweises auf die Patenterteilung: **01.06.1994**
(21) Anmeldenummer: 87907960.6
(22) Anmeldetag: 09.12.1987
(51) Int. Cl.: H01L 21/00, B23K 20/00

(54) **BALL-BONDVERFAHREN UND VORRICHTUNG ZUR DURCHFÜHRUNG DERSELBEN**
BALL BONDING PROCESS AND DEVICE
PROCEDE ET DISPOSITIF DE FIXATION PAR BILLE

(30) Priorität: 06.02.1987 DE 3703694
(43) Veröffentlichungstag der Anmeldung: 25.01.1989
(60) Teilanmeldung: 92115937.2
(73) Patentinhaber: F & K Delvotec Bondtechnik GmbH, D-82041 Oberhaching (DE)
(72) Erfinder: FARASSAT, Farhad, D-8000 München 71 (DE); BIRGEL, Walter, D-8016 Feldkirchen (DE)
(74) Vertreter: Popp, Eugen, Dr.
(86) Internationale Anmeldenummer: EP8700765
(87) Internationale Veröffentlichungsnummer: WO8805960

(56) Entgegenhaltungen:
- EP-A- 0 011 979
- US-A- 4 586 642

## Beschreibung

Die Erfindung betrifft ein Ball-Bondverfahren, wie ein Golddraht-Bondverfahren, nach dem Oberbegriff des Anspruches 1 und eine Vorrichtung zur Durchführung des Verfahrens nach dem Oberbegriff des Anspruches 4.

Ein solches Ball-Bondverfahren ist aus der US-A-4,586,642 bekannt. Bei diesem Verfahren wird zunächst der Bondkopf bzw. eine diesem zugeordnete Bond-Kapillare mit einer abgeflammten Bonddraht-Kugel (Ball) am unteren, freien Ende eines Bonddrahtes aus einer hochgefahrenen Ausgangsposition auf eine erste Bondstelle positioniert und abgesenkt. Sodann wird der Ball unter Wärmezugabe, definiertem Anpreßdruck und/oder Ultraschallunterstützung auf der ersten Bondstelle aufgeschweißt. Hiernach wird die Bondkapillare hochgefahren und eine Bonddraht-Schleife oder loop gebildet. Anschließend wird der Bonddraht wiederum unter Wärmezugabe, definiertem Anpreßdruck und/oder Ultraschallunterstützung an einer zweiten Bondstelle aufgeschweißt. Daraufhin wird der Bondkopf bzw. die Bond-Kapillare in eine vorgegebene tail-length-Position hochgefahren, der Bonddraht durch Ausübung eines Zuges auf diesen mittels einer am Bonddraht angreifenden Drahtklammer abgerissen und anschließend die Bond-Kapillare in die Ausgangsposition angehoben. Letztlich wird das freie Bonddrahtende unter Ausbildung eines neuen Balls abgeflammt, so daß dieses Ball-Bondverfahren erneut durchgeführt werden kann.

Ebenso ist in der US-A-4,586,642 eine Vorrichtung zur Durchführung dieses Ball-Bondverfahrens beschrieben. Diese Vorrichtung umfaßt eine Bond-Kapillare mit einem Bonddraht, die auf bzw. von Bondstellen zu- bzw. wegbewegbar, d. h. hier absenkbar bzw. hochfahrbar, ist. Des weiteren weist diese Vorrichtung eine am Bonddraht angreifende Drahtklammer auf, die ebenfalls auf bzw. von den Bondstellen zu- bzw. wegbewegbar und somit absenkbar bzw. hochfahrbar ist. Schließlich ist bei dieser Vorrichtung eine Einrichtung zum Anlegen einer elektrischen Spannung zwischen der Drahtklammer und der einen Bondstelle vorgesehen. Eine solche Einrichtung umfaßt einen ringförmigen, den Bonddraht umgebenden und zwischen der Bond-Kapillare einerseits und der Drahtklammer andererseits angeordneten Magnetkern sowie eine mit dem Magnetkern zusammenwirkende Spule, welche an einen Oszillator angeschlossen ist. Der Oszillator, der selbst in einem Computersystem integriert ist, erzeugt bestimmte Frequenzspannungen in vorgegebenen Zeitintervallen. Anhand einer Eichkurve, bei welcher die Frequenz über der Zeit aufgetragen ist, soll ein Vergleich mit der jeweiligen tatsächlichen Kurve des momentanen Bondvorganges, bei welcher ebenfalls die Frequenz über der Zeit aufgetragen ist, stattfinden können. Anhand eines solchen Vergleiches wiederum sollen bei einem bestimmten Bondvorgang auftretende Unregelmäßigkeiten durch Abweichungen in der Frequenz und/oder Zeit festgestellt und sodann für weitere nachfolgende Bondvorgänge durch entsprechende Korrektur behoben werden können.

Bei der zunehmend fortschreitenden Miniaturisierung der Bauelemente und damit der Bond- bzw. Kontaktstellen ist es erforderlich, die Ball-Größe entsprechend klein zu bemessen, um Kurzschlüsse zwischen benachbarten Bond- bzw. Kontaktstellen zu vermeiden. Darüberhinaus wird gefordert, die sog. "Mini-Balls" exakt zu dimensionieren. Diese beiden Voraussetzungen lassen sich jedoch mit dem herkömmlichen beschriebenen Ball-Bondverfahren nicht ohne weiteres erfüllen. Dies ist durch die Dehnung des meist sehr dünnen Golddrahtes bis zu 10 %, den Schlupf zwischen dem Bonddraht einerseits und der den Abriß desselben bewirkenden Drahtklammer andererseits sowie die durch innere Spannungen bedingte Verformung des Bonddrahtes, insbesondere seitliche Ausbiegung desselben, im unbelasteten Zustand nach der Aufschweißung an der zweiten Bondstelle bedingt. Eine Folge hiervon wiederum sind beim bisherigen Ball-Bondverfahren eine sehr undefinierte sog. "tail-length" und dementsprechend eine verhältnismäßig unbestimmte Ball-Größe.

Der vorliegenden Erfindung liegt die Aufgabe zugrunde, ein Ball-Bondverfahren der genannten Art sowie eine Vorrichtung zu dessen Durchführung zu schaffen, mit dem bzw. der sich die Ball-Größe exakt einstellen läßt, und zwar insbesondere auch bei Ausbildung von sog. "Mini-Balls".

Diese Aufgabe wird durch die kennzeichnenden Maßnahmen des Anspruches 1 in verfahrenstechnischer Hinsicht und durch die kennzeichnenden Merkmale des Anspruches 4 in vorrichtungstechnischer Hinsicht gelöst.

Das erfindungsgemäße Ball-Bondverfahren liefert neben der Lösung der gestellten Aufgabe zusätzlich weitere Informationen. Wenn bei dem Ball-Bondverfahren nach der Erfindung nämlich keine elektrische Verbindung zwischen der Drahtklammer und der Bondstelle bzw. dem Lead-fame herstellbar ist, sobald sich die Drahtklammer in Drahtklemmstellung befindet, bedeutet dies, daß keine "tail-Verbindung" zur zweiten Bondstelle vorhanden ist bzw. der Bonddraht ohne Einwirkung der Drahtklammer bereits abgerissen ist. In diesem Fall wird der Bonder insgesamt vorzugsweise abgeschaltet und nach Untersuchung und Beseitigung des Fehlers wieder neu eingestellt. Das erfindungsgemäße Ball-Bondverfahren erlaubt also, zusätzlich Fehlersignale zu erkennen.

Weitere Details des erfindungsgemäßen Ball-Bondverfahrens sind in den Ansprüchen 2 und 3 beschrieben.

Darüber hinaus ermöglicht die erfindungsgemäße Vorrichtung nach Anspruch 4 eine Durchführung des zuvor beschriebenen Ball-Bondverfahrens.

Vorteilhafte Merkmale der erfindungsgemäßen Vorrichtung sind in Anspruch 5 beschrieben.

Nachstehend wird anhand einer Prinzip-Zeichnung das erfindungsgemäße Verfahren nochmals erläutert. Es zeigen:

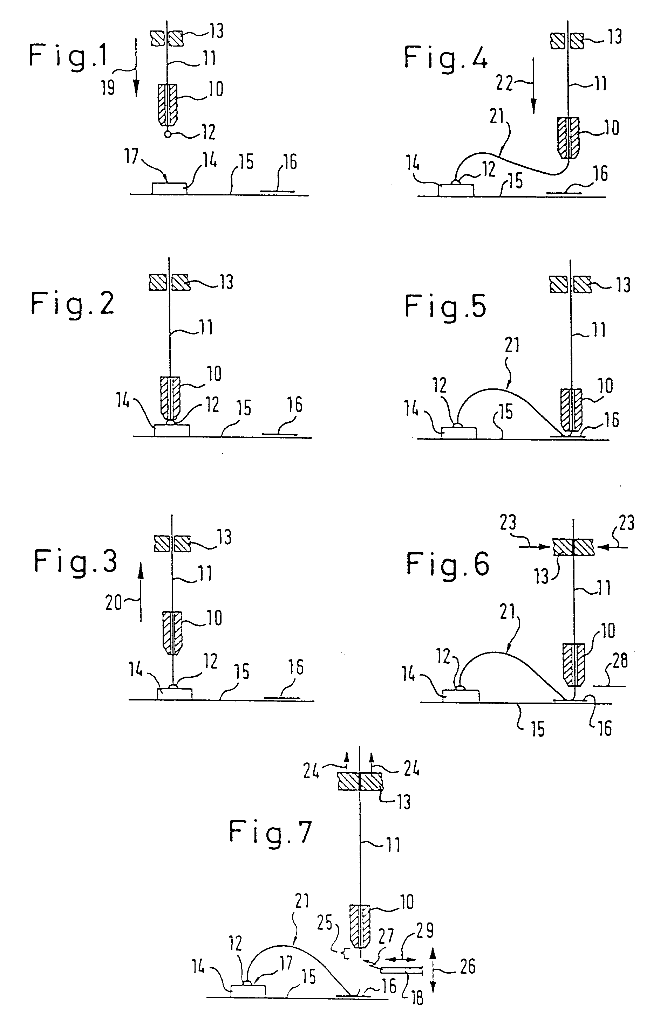

- Fig. 1 bis 7: den prinzipiellen Verfahrensablauf des erfindungsgemäßen Ball-Bondverfahrens.

In der anliegenden Zeichnung sind mit der Bezugsziffer 10 eine Bond-Kapillare, 11 ein Gold-Bonddraht mit einem Mini-Ball 12 am unteren freien Drahtende, 13 eine am Bonddraht 11 angreifende Drahtklammer, 14 ein Bauelement mit einer ersten Bondstelle 17, 15 ein Lead-frame, 16 eine zweite Bondstelle auf dem lead-frame bzw. Substrat, und 18 eine Abflammlanze gekennzeichnet.

Ausgehend von einer hochgefahrenen Ausgangsposition eines im einzelnen nicht näher dargestellten Bondkopfes samt Bond-Kapillare 10 mit abgeflammter Bonddraht-Kugel bzw. Ball 12 auf eine erste Bondstelle 17 auf einem Bauelement 14 abgesenkt entsprechend Pfeil 19 in Fig. 1. Die Absenkung der Bond-Kapillare 10 erfolgt unter Mitnahme des Balls 12 und damit entsprechender Mitnahme des Bonddrahtes 11. Anschließend erfolgt das Aufschweißen des Balls 12 an der ersten Bondstelle 17 auf dem Bauelement 14 unter Wärmezugabe, definiertem Anpreßdruck und/oder Ultraschallunterstützung.

Dann wird der Bondkopf bzw. die Bond-Kapillare 10 wieder hochgefahren (siehe Pfeil 20 in Fig. 3) und in eine vorgegebene Loop-Position entsprechend Fig. 4 bewegt, unter Ausbildung einer sogenannten Bonddraht-Schleife 21. In der Loop-Position befindet sich die Bond-Kapillare oberhalb der zweiten Bondstelle 16. Die Bond-Kapillare wird dann unter entsprechender Mitnahme des Bonddrahtes 11 aus der Loop-Position erneut abgesenkt (siehe Pfeil 22 in Fig. 4). In abgesenkter Stellung entsprechend Fig. 5 erfolgt dann das Aufschweißen des Bonddrahtes 11 an der zweiten Bondstelle 16 ebenfalls unter Wärmezugabe, definiertem Anpreßdruck und/oder Ultraschallunterstützung.

Dann wird der Bondkopf bzw. die Bond-Kapillare 10 in tail-length-Position 28 gefahren entsprechend Fig. 6. Anschließend wird die Drahtklammer 13 aktiviert und entsprechend den Pfeilen 23 in Fig. 6 in Drahtklemmstellung gebracht. Dann wird zwischen der Drahtklammer und der zweiten Bondstelle 16 eine elektrische Spannung angelegt, gegebenenfalls über den lead-frame 15. Sobald diese Spannung anliegt wird die Drahtklammer 13 entsprechend den Pfeilen 24 in Fig. 7 nach oben bewegt bzw. hochgefahren unter entsprechender Ausübung eines Zuges auf den Bonddraht 11, bis dieser abreißt. Mit dem Abriß des Bonddrahtes 11 wird die elektrische Verbindung zwischen Drahtklammer 13 und zweiter Bondstelle 16 unterbrochen. Die Zug- bzw. Abreißbewegung der Drahtklammer 13 wird gestoppt. Gleichzeitig wird die Wegstrecke festgehalten, die die Drahtklammer 13 in Richtung der Pfeile 24 bis zum Abriß des Bonddrahtes 11 zurückgelegt hat. Auf diese Weise ist die tatsächliche tail-length 25 (Fig. 7) bzw. die exakte Position des freien Bonddrahtendes oberhalb der zweiten Bondstelle 16 bestimmbar, so daß es möglich ist, die Einrichtung zum Abflammen des freien Bonddrahtendes unter Ausbildung eines neuen Balls 12, nämlich die Abflammlanze 18, gegenüber dem freien Bonddrahtende bzw. der Drahtspitze so zu Positionieren (siehe Doppelpfeil 26 in Fig.7 ), daß die Abflammlanze 18 stets einen vorbestimmten Abstand zur Bonddrahtspitze aufweist. Dann wird die Abflammlanze 18 aktiviert (Abflammfunke 27), so daß sich der tail 25 zu einem neuen Ball 12 verformt.

Anschließend wird die Drahtklammer 13 wieder geöffnet und in die Ausgangsposition gemäß Fig. 1 abgesenkt. Ein neuer Bondvorgang der beschriebenen Art kann wieder beginnen.

Als Antrieb für die Drahtklammer 13 dient vorzugsweise ein Schrittmotor. Die von der Drahtklammer 13 zurückgelegte Wegstrecke bis zum Abriß des Bonddrahtes 11 wird dementsprechend in Schritten (clocks) festgehalten. Vorzugsweise erfolgt die Auf- und Abbewegung der Abflammlanze 18 in Richtung des Doppelpfeiles 26 ebenfalls mittels eines Schrittmotors, wobei die Zählwerke der beiden Schrittmotoren über eine Rechnereinheit miteinander gekoppelt sind, so daß die gewünschte Zuordnung der Abflammlanze 18 zur freien Drahtspitze selbsttätig bzw. vollautomatisch herstellbar ist.

Sobald sich die Drahtklammer 13 wieder in ihrer Startposition gemäß Fig. 1 befindet, wird das der Drahtklammer 13 zugeordnete Zählwerk wieder auf Null gestellt. Auch die Abflammlanze 18 wird nach dem Abflammen des tails 25 wieder in eine Nullposition gebracht. Sobald diese erreicht ist, wird das dem Antrieb der Abflammlanze 18 zugeordnete Zählwerk ebenfalls auf Null gestellt. Sowohl die Drahtklammer 13 als auch die Abflammlanze 18 befinden sich somit jeweils in Ausgangs- bzw. Startposition, von der aus die gegenseitige Positionierung von freier Drahtspitze und Abflammlanze 18 bestimmt und gesteuert wird.

Durch das beschriebene Verfahren ist es möglich, die eingangs genannten Erscheinungen bzw. Größen, wie Drahtdehnung und Drahtverformung (seitliche Ausbiegung im unbelasteten Zustand), als Fehlgrößen zur exakten Ball-Dimensionierung auszuschließen.

Bei dem Verfahren ist von weiterhin Vorteil, daß sich ein vorzeitiger Abriß des Bonddrahtes ohne Einwirkung der Drahtklammer 13 feststellen läßt, und zwar dann, wenn nach dem Schließen der Drahtklammer 13 eine elektrische Verbindung zwischen derselben und der zweiten Bondstelle 16 nicht herstellbar ist.

## Patentansprüche

1. Ball-Bondverfahren, wie ein Golddraht-Bondverfahren, welches folgende Arbeitsschritte umfaßt:
a) Positionieren und Absenken einer Bond-Kapillare (10) mit einer abgeflammten Bonddraht-Kugel (Ball 12) am unteren, freien Ende eines Bonddrahtes (11) aus einer hochgefahrenen Ausgangsposition auf eine erste Bondstelle (17);
b) Aufschweißen des Balls (12) unter Wärmezugabe, definiertem Anpreßdruck und/oder Ultraschallunterstützung;
c) Hochfahren der Bond-Kapillare (10);
d) Bildung einer Bonddraht-Schleife (21);
e) Aufschweißen des Bonddrahtes (11) an einer zweiten Bondstelle (16) unter Wärmezugabe, definiertem Anpreßdruck und/oder Ultraschallunterstützung;
f) Hochfahren der Bond-Kapillare (10) in eine vorgegebene tail-length-Position (28), Abreißen des Bonddrahtes (11) durch Ausübung eines Zuges auf diesen mittels einer am Bonddraht (11) angreifenden Drahtklammer (13) und anschließend Hochfahren der Bond-Kapillare (10) in die Ausgangsposition; sowie
g) Abflammen des freien Bonddrahtendes unter Ausbildung eines neuen Balls (12)
**dadurch gekennzeichnet,** daß
h) nach dem Aufschweißen des Bonddrahtes (11) an der zweiten Bondstelle (16) die Drahtklammer (13) aktiviert und in Drahtklemmstellung gebracht wird;
i) dann zwischen der Drahtklammer (13) und der zweiten Bondstelle (16) eine elektrische Spannung angelegt wird;
j) hieraufhin die Drahtklammer (13) unter Ausübung eines Zuges auf den Bonddraht (11) hochgefahren und beim Abriß des Bonddrahtes (11) durch Unterbrechung der elektrischen Verbindung zwischen Drahtklammer (13) und zweiter Bondstelle (16) angehalten wird; ;
k) anschließend die Wegstrecke der Drahtklammer (13) bis zum Abriß des Bonddrahtes (11) und damit bis zur Unterbrechung der elektrischen Verbindung zwischen Drahtklammer (13) und zweiter Bondstelle (16) gemessen wird; und
l) eine als Einrichtung zum Abflammen des freien Bonddrahtes vorgesehene Abflammlanze (18) unter Berücksichtigung der gemessenen Drahtklammer-Wegstrecke dem freien Bonddrahtende bzw. der Drahtspitze so zugeordnet wird, daß die Abflammlanze (18) einen vorbestimmten Abstand zum freien Bonddrahtende bzw. zur Drahtspitze aufweist.

2. Verfahren nach Anspruch 1,
dadurch gekennzeichnet, daß
die zum Abreißen des an der zweiten Bondstelle (16) aufgeschweißten Bonddrahtes (11) dienende Drahtklammer (13) schrittweise (clock-wise) hochgefahren wird unter Zählung der Bewegungsschritte bis zum Abriß des Bonddrahtes (11).

3. Verfahren nach Anspruch 2,
dadurch gekennzeichnet, daß
nach Abriß des Bonddrahtes (11) ein der Drahtklammer (13) zugeordnetes Bewegungsschrittzählwerk wieder auf Null gestellt wird.

4. Vorrichtung zur Durchführung des Verfahrens nach einem oder mehreren der Ansprüche 1 bis 3 umfassend eine Bond-Kapillare (10) mit einem Bonddraht (11), die auf bzw. von Bondstellen (16, 17) zu- bzw. wegbewegbar ist, einer am Bonddraht (11) angreifenden Drahtklammer (13), die auf bzw. von den Bondstellen (16, 17) zu- bzw. wegbewegbar ist, und einer Einrichtung zum Anlegen einer elektrischen Spannung zwischen der Drahtklammer (13) und der einen Bondstelle (16),
dadurch gekennzeichnet, daß
der den Abriß des Bonddrahtes (11) bewirkenden Drahtklammer (13) ein Schrittantrieb zugeordnet ist, der mit einem Zählwerk gekoppelt ist, welches die von der Drahtklammer (13) zurückgelegte Wegstrecke bestimmt und für die erneute Bestimmung einer weiteren Wegstrecke auf Null einstellbar ist.

5. Vorrichtung nach Anspruch 4,
dadurch gekennzeichnet, daß
eine als Einrichtung zum Abflammen des freien Bonddrahtendes vorgesehene Abflammlanze (18) auf bzw. von den Bondstellen (16, 17) zu bzw. wegbewegbar ist, wobei der Abflammlanze (18) ein Schrittantrieb zugeordnet ist, der mit einem Zählwerk gekoppelt ist, welches die von der Abflammlanze (18) zurückgelegte Wegstrecke bestimmt und für die erneute Bestimmung einer weiteren Wegstrecke auf Null einstellbar ist.

## Claims

1. A ball-bonding method, such as a gold wire bonding method comprising the following steps:
a) Positioning and lowering a bonding capillary (10) with a flame-cut bonding wire-ball (ball 12) at the lower free end of a bonding wire (11) from a raised starting position to a first bonding point (17);
b) Welding the ball (12) whilst adding heat, at a defined contact pressure and/or with ultrasound support;
c) Raising the bonding capillary (10);
d) Forming a loop (21) of the bonding wire;
e) Welding the bonding wire (11) at a second bonding point (16) whilst adding heat, at a defined contact pressure and/or with ultrasound support;
f) Raising the bonding capillary (10) into a predetermined tail-length position (28), tearing off the bonding wire (11) by virtue of pulling the bonding wire (11) by means of a wire clip (13) engaging the bonding wire (11) and subsequently raising the bonding capillary (10) into the starting position; and
g) Flame-cutting the free end of the bonding wire whilst forming a new ball (12)
characterised in that:
h) after welding the bonding wire (11) at the second bonding point (16), the wire clip (13) is activated and moved into the wire clamping position,
i) then an electrical voltage is provided between the wire clip (13) and the second bonding point (16),
j) the wire clip (13) is then raised whilst pulling the bonding wire (11) and stopped upon tearing off the bonding wire (11) by interrupting the electrical connection between the wire clip (13) and the second bonding point (16),
k) subsequently a measurement is taken of the distance travelled by the wire clip (13) until the bonding wire (11) is torn off and thus until the electrical connection between the wire clip (13) and the second bonding point (16) is interrupted and that
l) a flame-cutting lance (18) provided as a device for flame-cutting the free bonding wire, whilst taking into consideration the measured distance travelled by the wire clip, is allocated to the free bonding wire end or the wire tip in such a way that the flame cutting lance (18) comprises a predetermined distance to the free bonding wire end or to the wire tip.

2. A method according to claim 1, characterised in that the wire clip (13), which serves to tear off the bonding wire (11) welded at the second bonding point (16), is raised stepwise (clock-wise) whilst counting the movement steps until the bonding wire (11) is torn off.

3. A method according to claim 2, characterised in that, after the bonding wire (11) has been torn off, a numerical value relating to the movement step and allocated to the wire clip (13) is reset to zero.

4. A device for carrying out the method according to one or several of the claims 1 to 3 comprising a bonding capillary (10) with a bonding wire (11), which capillary can be moved towards and away from the bonding points (16,17), a wire clip (13) engaging the bonding wire (11), which wire clip can be moved towards and away from the bonding points (16, 17) and a device for providing an electrical voltage between the wire clip (13) and one bonding point (16), characterised in that a stepping drive is allocated to the wire clip (13), which effects the tearing off of the bonding wire (11), which stepping drive is connected to a counting device, which determines the distance travelled by the wire clip (13) and can be reset to zero for the purpose of determining again a further distance travelled.

5. A device according to claim 4, characterised in that a flame-cutting lance (18) provided as a device for the purpose of flame-cutting the free end of the bonding wire can be moved towards or away from the bonding points (16,17), wherein the flame-cutting lance (18) is allocated a stepping drive which is connected to a counting device, which determines the distance travelled by the flame-cutting lance (18) and can be reset to zero for the purpose of determining again a further distance travelled.

## Revendications

1. Procédé de fixation par bille, tel qu'un procédé de fixation par fil d'or, comprenant les étapes de travail suivantes :
a) positionnement et abaissement d'un tube capillaire de fixation (10) muni d'une boule de fixation flambée (bille 12) à l'extrémité libre inférieure d'un fil de fixation (11), d'une position de départ relevée à une première position de fixation (17);
b) soudage de la bille (12) avec apport de chaleur, pression d'appui définie et/ou assistance d'ultrasons;
c) remontée du tube capillaire de fixation (10);
d) formation d'une boucle de fil de fixation (21);
e) soudage du fil de fixation (11) en un second point de fixation (16) avec apport de chaleur, pression d'appui définie et/ou assistance d'ultrasons;
f) remontée du tube capillaire de fixation (10) en une position "tail-length" prédéterminée (28), rupture du fil de fixation (10) en exerçant une traction sur celui-ci au moyen d'une pince à fil (13) en prise avec le fil de fixation (11) et ensuite remontée du tube capillaire de fixation (10) dans la position de départ; ainsi que
g) flambage de l'extrémité libre du fil de fixation avec formation d'une nouvelle bille (12),
caractérisé en ce que :
h) après le soudage du fil de fixation (11) au second point de fixation (16), la pince à fil (13) est activée et amenée en position de serrage du fil;
i) une tension électrique est ensuite établie entre la pince à fil (13) et le second point de fixation (16);
j) subséquemment la pince à fil (13) est relevée en exerçant une traction sur le fil de fixation (11) et immobilisée lors de la rupture du fil de fixation (11) par interruption de la liaison électrique entre la pince à fil (13) et le second point de fixation (16);
k) le trajet de la pince à fil (13) jusqu'à la rupture du fil de fixation (11) et par suite jusqu'à l'interruption de la liaison électrique entre la pince à fil (13) et le second point de fixation (16) est ensuite mesuré; et
l) une lance de flambage (18) prévue comme moyen de flambage du fil de fixation libre est associée de telle manière à l'extrémité libre du fil de fixation ou du bout de fil, en tenant compte du trajet mesuré de la pince à fil, que la lance de flambage (18) est à une distance prédéterminée de l'extrémité libre du fil de fixation ou du bout de fil.

2. Procédé selon la revendication 1, caractérisé en ce que la pince à fil (13) servant à la rupture du fil de fixation (11) soudé au second point de fixation (16) est remontée pas à pas (clock-wise) avec comptage des pas de déplacement jusqu'à la rupture du fil de fixation (11).

3. Procédé selon la revendication 2, caractérisé en ce qu'après rupture du fil de fixation (11), un compteur de pas de déplacement associé à la pince à fil (13) est remis à zero.

4. Dispositif pour la mise en oeuvre du procédé selon une ou plusieurs des revendications 1 à 3 comprenant un tube capillaire de fixation (10) muni d'un fil de fixation (11), qui peut être approché et éloigné de points de fixation (16, 17), une pince à fil (13) en prise avec le fil de fixation (11), qui peut être approchée et éloignée des points de fixation (16, 17), et des moyens pour établir une tension électrique entre la pince à fil (13) et l'un des points de fixation (16), caractérisé en ce qu'un moteur pas à pas est associé à la pince à fil (13) qui provoque la rupture du fil de fixation (11), couplé à un compteur qui détermine le trajet parcouru par la pince à fil (13) et peut être remis à zéro pour la nouvelle détermination d'un trajet ultérieur.

5. Dispositif selon la revendication 4, caractérisé en ce qu'une lance de flambage (18) prévue en tant que moyen pour le flambage de l'extrémité libre du fil de fixation peut être approchée et éloignée des points de fixation (16, 17), un moteur pas à pas étant associé à la lance de flambage (18), couplé à un compteur qui détermine le trajet parcouru par la lance de flambage (18) et peut être remise à zéro pour une nouvelle détermination d'un trajet ultérieur.
